# EUROPÄISCHE PATENTSCHRIFT

(11) **EP 3 106 811 B1**
(45) Veröffentlichungstag und Bekanntmachung des Hinweises auf die Patenterteilung: **20.11.2019**
(21) Anmeldenummer: 16173801.8
(22) Anmeldetag: 09.06.2016
(51) Int. Cl.: H01L 21/67, F27B 5/04, F27B 5/10, F27D 1/00, F27D 1/04, F27D 1/06

(54) **SUSZEPTOR**
SUSCEPTOR
SUSCEPTEUR

(30) Priorität: 16.06.2015 DE 202015103154 U
(43) Veröffentlichungstag der Anmeldung: 21.12.2016
(73) Patentinhaber: Graphite Materials GmbH, 90513 Zirndorf (DE)
(72) Erfinder: Lassel, Eduard, 90451 Nürnberg (DE)
(74) Vertreter: Tergau, Dietrich

(56) Entgegenhaltungen:
- EP-A1- 2 730 875
- WO-A1-2013/178824
- JP-A- 2000 171 160
- US-A- 5 912 080
- US-A1- 2007 128 569

## Beschreibung

Die vorliegende Erfindung betrifft einen Suszeptor, welcher auch als Muffel bezeichnet wird. Derartige Suszeptoren bestehen aus Graphit oder aus kohlenstofffaserverstärkten Kohlenstoffen, sogenannten CFC-Werkstoffen. Die Suszeptoren werden in den Prozessräumen von Schutzgas- und Vakuum-Hochtemperatur-Prozessanlagen eingesetzt. Derartige Anlagen sind beispielsweise die Öfen zum Aushärten von Hartmetallrohlingen. Die Prozessanlagen sind an ihren Enden jeweils mit einem Deckel verschließbar. Die Suszeptoren sind im Prozessbereich der Prozessanlagen angeordnet und dienen als eigentliche Kammer zur Fertigung der jeweiligen Teile. Auch die Suszeptoren sind an ihren Enden mit Hilfe von Graphitdeckeln oder CFC-Deckeln verschließbar. Üblicherweise sind diese Suszeptoren-Deckel kinematisch mit den Ofentüren gekoppelt.

Da die Prozesse in den Suszeptoren üblicherweise unter Überdruck stattfinden, müssen die Suszeptoren druckbeständig sein. Da die Prozesse außerdem mit hohen Temperaturen arbeiten, muss der Suszeptor so aufgebaut sein, dass sich das Material bei steigender Temperatur ausdehnen kann, ohne dass der Suszeptor seine Druckfestigkeit verliert.

Üblicherweise sind Suszeptoren tunnelartig aufgebaut. Sie weisen einen ebenen durchgehenden Boden auf. Über diesem Boden erstrecken sich Kreissegmente, die größer als 180°, üblicherweise sogar größer als 270° sind. Die Kombination aus den Kreissegmenten und der Bodenfläche ergibt den tunnelförmigen Suszeptor.

Ein Suszeptor der eingangs genannten Art ist beispielsweise aus der DE 10 2012 209 278 A1 bekannt. Dieser bekannte Suszeptor setzt sich aus einer Vielzahl von zweiteiligen, jeweils aus einem Bodenelement und einem Kreissegment zusammengesetzten und somit zweiteiligen Modulen zusammen. Die beiden Bauteile eines Moduls weisen eine sehr homogene Werkstoffqualität auf. Sie sind nämlich üblicherweise aus ein und demselben Rohling gefertigt. Als Folge dieser Homogenität der verwendeten Werkstoffe ist das Wärmeausdehnungsverhalten, insbesondere ist der Wärmeausdehnungskoeffizient eines Moduls in sämtlichen Bereichen gleich.

Als nachteilig hat sich jedoch die modulartige Zusammensetzung des Suszeptor-Bodens erwiesen. In Folge des modularen Aufbaus des Suszeptor setzt sich der Suszeptor-Boden auch aus einer Vielzahl von Einzelelementen zusammen. Die im Suszeptor zu verarbeitenden, insbesondere die zu härtenden Rohlinge weisen ein sehr hohes Eigengewicht auf. Wird der Ofen und damit der Suszeptor mit den Rohlingen beschickt, wird die Ofentür und mit der Ofentür die Beschickungsöffnung des Suszeptors geöffnet. Das schwere Material wird in der Regel mit einem Stapler an den Ofen heran gefahren und über ein Schienensystem vom Stapler in den Ofen vorgeschoben. Beim Lastübergang vom Stapler auf die Beschickungsöffnung des Ofens wirken sehr hohe Kräfte auf den Bodenbereich des ersten, sich an die Beschickungsöffnung anschließenden Suszeptormoduls. Dies führt häufig zu Materialausbrüchen am Suszeptormodul im Bereich der Beschickungsöffnung beziehungsweise zum Totalausfall des ersten Suszeptormoduls.

Ausgehend hiervon liegt der Erfindung die Aufgabe zugrunde, einen Suszeptor so auszugestalten, dass er einerseits ein für den Verarbeitungsprozess geeignetes Wärmeausdehnungsverhalten aufweist und zum anderen ein Bodenelement mit einer hohen Tragfähigkeit vorhanden ist, um Beschädigungen des Suszeptors beim Beladen und beim Entladen zu verhindern.

Zur Lösung dieser Aufgabe ist vorgeschlagen, den Suszeptor aus mindestens zwei Modulen zu fertigen. Gemäß der Erfindung ist das endseitige Modul einstückig gefertigt. Das endseitige Modul ist also von einem Monolithen mit in sich geschlossenem Querschnitt gebildet. Da das endseitige Modul im Bereich der Beschickungsöffnung angeordnet ist, ist die Stabilität des Moduls mit monolithischem Körper gegenüber dem Stand der Technik derart gesteigert, dass ein beschädigungsfreies Be- und Entladen des Suszeptors einfach möglich ist.

Die rückbezogenen Ansprüche lehren teilweise vorteilhafte und teilweise für sich selbst erfinderische Weiterbildungen dieser Erfindung.

In vorteilhafter Ausgestaltung ist vorgesehen, dass der Suszeptor im Bereich seiner Beschickungsöffnung einen verschließbaren Deckel aufweist und dass sich das endseitige, monolithische ausgebildete Modul in Längsrichtung des Suszeptors unmittelbar an diese Beschickungsöffnung anschließt. Dies ermöglicht einen besonders guten Be- und Entladevorgang.

In weiterer vorteilhafter Ausgestaltung weisen sowohl die Prozessanlage, also der Ofen als auch der Suszeptor eine Beschickungsöffnung am einen und eine Revisionsöffnung am anderen Ende auf. Beide Öffnungen sind jeweils von einem Deckel verschlossen. An die Beschickungsöffnung einerseits und die Revisionsöffnung andererseits schließt sich jeweils ein monolithisch augebildetes Modul an. Der Suszeptor ist dadurch an beiden Öffnungen, die oftmals die Schwachstellen des Suszeptors bilden, besonders stabil ausgeführt. Außerdem ist es vorteilhaft, dass für beide monolithisch ausgebildeten Module gleiche Bauteile verwendet werden können.

In weiterer vorteilhafter Ausgestaltung ist zwischen den beiden monolithisch ausgebildeten Modulen eine durchgehende Bodenplatte angeordnet. Die Bodenplatte trägt ein großes einteiliges Kreissegment oder mehrere mit ihren Stirnflächen aneinander gereihte Kreissegmente. Die Kreissegmente sind im Bereich des Plattenrands der Bodenplatte mit der Bodenplatte verschraubt.

In weiterer Ausgestaltung kann aus den Kreissegmenten ein Kragen jeweils in Richtung auf das benachbarte Kreissegment hinausstehen, welcher in eine entsprechende Einformung am Nachbar-Kreissegment eingreift. Die Module können miteinander verschraubt oder verstiftet sein. Eine Verstiftung hat den Vorteil, dass die Module sich gegeneinander unter Wärmeeinfluss geringförmig verformen können, ohne die Dichtigkeit des Suszeptors herabzusetzen. Die durchgehende Bodenplatte hat den Vorteil, dass die auf die Bodenplatte einwirkenden Lasten über deren Gesamtfläche gut verteilt und abgetragen werden können.

Um auch den Übergang zwischen den monolithisch ausgestalteten Endmodulen und der Bodenplatte besonders stabil auszugestalten sind in die Bodenflächen der monolithischen Körper beziehungsweise Endmodule und die Bodenplatte Ausnehmungen eingebracht, um in den Ausnehmungen eine die Ausnehmungen überbrückende Ankerplatte vorzusehen. Mit Hilfe dieser Ankerplatte können jeweils ein monolithischer Körper und ein Ende der Bodenplatte miteinander verbunden werden. Besonders vorteilhaft ist es in diesem Zusammenhang eine Vielzahl von Verschraubungen zwischen der Ankerplatte und der Bodenplatte einerseits und der Bodenfläche des monolithischen Körpers andererseits vorzusehen. Als besonders vorteilhaft wird es angesehen, die Randbereiche der Ankerplatte mit Stufen zu versehen, so dass aus der Ankerplatte im Bereich der jeweiligen Stufe eine Montagezunge vorsteht. Hierbei ist es besonders vorteilhaft, die in Längsrichtung vorstehenden Montagezungen gegenüber den in Querrichtung vorstehenden Montagezungen um 180° zueinander zu verdrehen. Die Ankerplatte weist einen gleichsam kreuzförmigen Querschnitt auf. Die um 180° gegeneinander verschwenkten Stufen bewirken, dass die Ankerplatte einmal die Oberseite der Bodenplatte beziehungsweise der Bodenfläche des monolithischen Körpers an ihren Oberseiten überlappt und andererseits die Unterseite der Bodenplatte beziehungsweise der Bodenfläche des monolithischen Körpers von den beiden anderen Montagezungen gleichsam unterfahren wird. Besonders vorteilhaft ist es an der Bodenplatte und an der Bodenfläche des monolithischen Körpers entsprechend zurückspringende komplementär ausgestaltete Montageflächen vorzusehen. Dies hat den Vorteil, dass sowohl auf der Oberseite der Bodenfläche des monolithischen Körpers und der Bodenplatte als auch auf deren Unterseite eine durchgehende ebene Fläche ohne emporstehende Befestigungsmittel entsteht, was eine behinderungsfreie Einbringung des Materials in den Suszeptor begünstigt.

Die vorstehend beschriebene Kombination aus Montagezungen und Montageflächen hat darüber hinaus den Vorteil, dass eine Vielzahl von Verschraubungen im Bereich der Montagezungen und der Montageflächen nebeneinander angeordnet werden kann, so dass eine besonders gute Kraftverteilung realisiert ist. Vor allem wird dadurch verhindert, dass die einzelne Verschraubung durch plötzlich aufgestellte Lasten beschädigt wird und ausfällt.

Für die Realisierung besonders langer Suszeptoren ist es mit der Erfindung auch möglich, die Bodenplatte aus mehreren Teilplatten zusammenzusetzen, welche wiederum die vorbeschriebene Ausnehmungen für die Ankerplatten aufweisen. Auch die in Längsrichtung hintereinander angeordneten Teilplatten können über Ankerplatte miteinander verbunden werden.

Schließlich wird es als vorteilhaft angesehen, die für den Fertigungsprozess erforderliche Entwachsungsöffnung in die Bodenflächen der monolithischen Körper einzubringen, da sie beim Fertigungsprozess von aufstehenden Lasten in der Regel nicht verdeckt werden.

Anhand des in den Zeichnungsfiguren dargestellten Ausführungsbeispiels ist die Erfindung mit weiteren Einzelheiten erläutert. Es zeigen:
- Fig. 1: eine Explosionsdarstellung eines Ausführungsbeispiels eines erfindungsmäßigen Suszeptors ohne die verschließbaren Deckel,

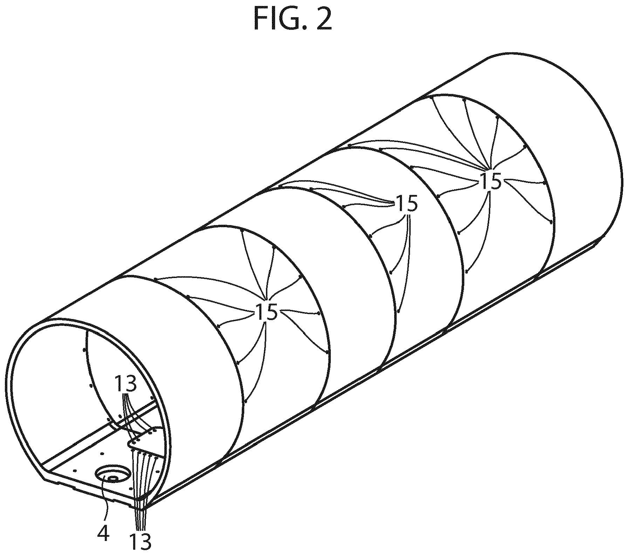

- Fig. 2: den in Fig. 1 dargestellten Suszeptor im zusammengebauten Zustand,

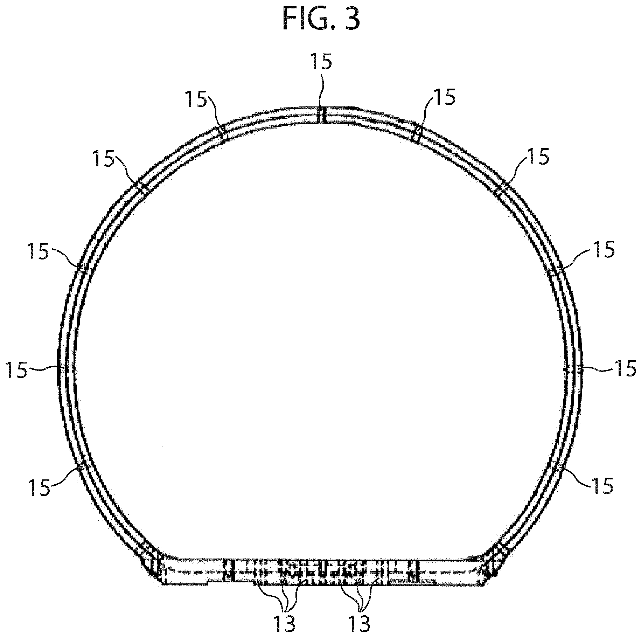

- Fig. 3: eine Seitenansicht des in Fig. 2 dargestellten Suszeptors,
- Fig. 4: eine Draufsicht auf den in Fig. 3 dargestellten Suszeptor und
- Fig. 5: den Schnitt V - V aus Fig. 4.

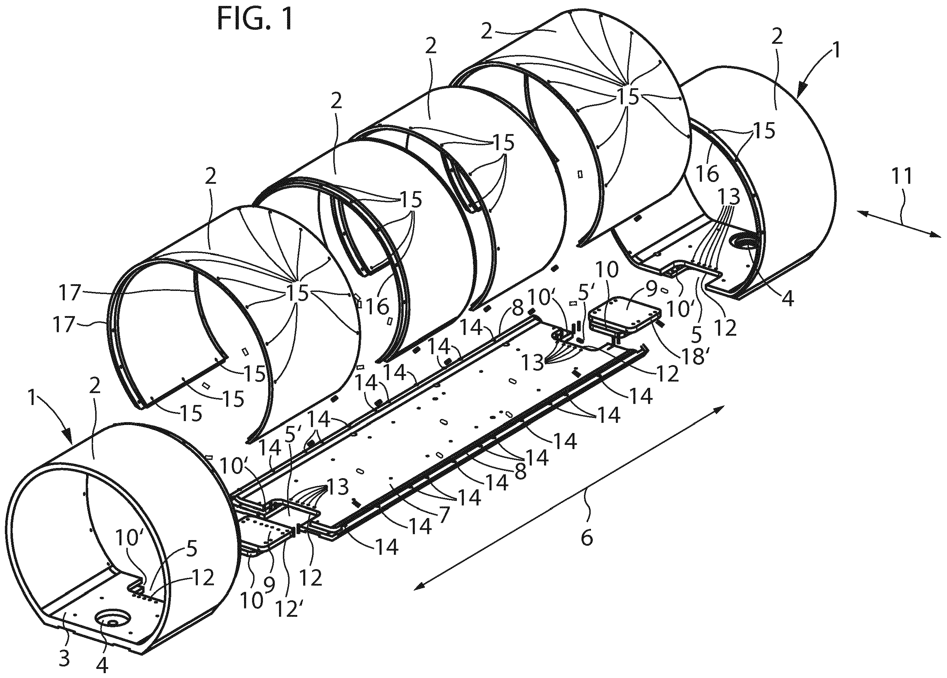

In Fig. 1 sind an den Endseiten jeweils Endmodule dargestellt, welche als monolithische Körper 1 ausgestaltet sind. Beim Ausführungsbeispiel sind aus einem Graphitblock einstückig das Kreissegment 2 und die Bodenfläche 3 aus einem Vollkörper ausgeschnitten. Der monolithische Körper 1 ist gleichsam als an einer Seite abgeflachter Ring ausgestaltet. In die Bodenfläche 3 des monolithischen Körpers 1 ist weiterhin eine Entwachsungsöffnung 4 eingebracht. Diese Entwachsungsöffnung 4 ist mit einem Entwachsungsrohr verbunden, um verdampfendes Bindemittel aus dem Suszeptor abtransportieren zu können. In die Bodenfläche 3 des monolithischen Körpers 1 ist jeweils eine Ausnehmung 5 eingebracht.

In Längsrichtung 6 ist zwischen den beiden monolithischen Körpern 1 eine Bodenplatte 7 angeordnet. Die Bodenplatte 7 hat einen im Wesentlichen rechteckförmigen Querschnitt. An den Langseiten der Bodenplatte 7 ist jeweils ein vorspringender Montagerand 8 ausgebildet. Die Schmalseiten der Bodenplatte 7 sind jeweils einem der monolithischen Körper 1 zugewandt. Aus den Schmalseiten sind etwa mittig den Ausnehmungen 5 in den monolithischen Körpern 1 entsprechende Ausnehmungen 5' ausgeschnitten.

Die Ausnehmungen 5, 5' sind so ausgestaltet, dass sie - im Ausführungsbeispiel quadratische - Ankerplatten 9 aufnehmen. In Längsrichtung 6 stehen aus den Ankerplatten 9 Montagezungen 10 hinaus. In der zur Längsrichtung 6 rechtwinklig verlaufenden Querrichtung 11 sind entsprechende Montagezungen 10' an der Bodenplatte 7 und an den Bodenflächen 3 im Bereich der Ausnehmung 5, 5' angeordnet. Die Montagezungen 10, 10' entstehen einfach durch die Einformung jeweils einer Stufe in den Rand der Ankerplatte 9 beziehungsweise den Rand der Ausnehmungen 5, 5'.

Zu den Montagezungen 10 sind entsprechende nach Art von Rücksprüngen gestaltete Montageflächen 12 an den in Querrichtung 11 verlaufenden Rändern der Ausnehmungen 5, 5' angeordnet. Die Montageflächen 12 sind als stufenförmige Rücksprünge ausgestaltet. Entsprechende Montageflächen 12' weist die Ankerplatte 9 auf. Die Montageflächen 12' an den Ankerplatten 9 verlaufen in Längsrichtung 6 und sind ebenfalls als rückspringende Stufen ausgestaltet.

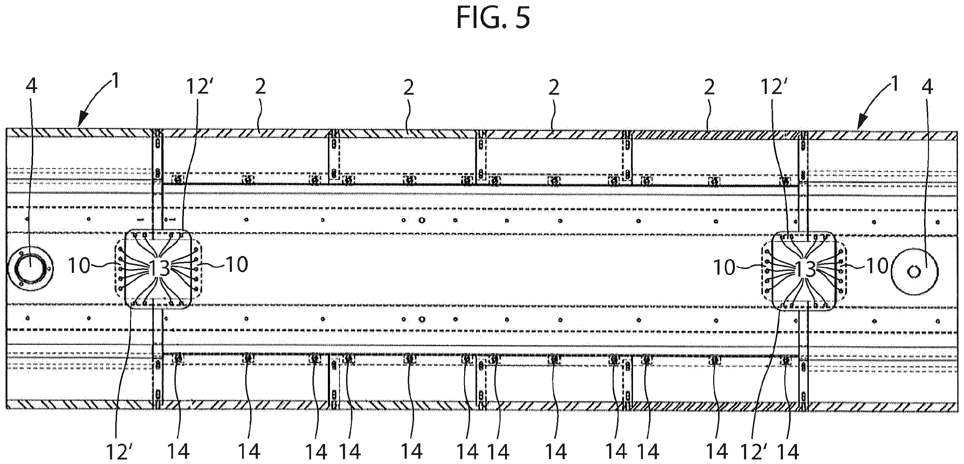

Die Ankerplatte 9 besteht somit im Ausführungsbeispiel aus einem quadratischen Kern, aus dessen Oberseite in Querrichtung 11 im Ausführungsbeispiel zwei Montageflächen 12' und in Längsrichtung 6 zwei Montagezungen 10 hinausstehen. Man kann sich die Querschnittsform der Montageplatte auch als eine Kombination zweier übereinander gelegter und um 90° verschwenkter Rechtecke vorstellen. Dies ist aus der Darstellung der Fig. 5 gut ersichtlich.

Zur Montage aneinander sind die vorerwähnten Montagezungen 10, 10' und Montageflächen 12, 12' von Bohrungen 13 durchsetzt. In den Bohrungen 13 durchsetzen Verschraubungen die Montagezungen 10, 10' und die Montageflächen 12, 12'. Durch die Vielzahl von Verschraubungen in den Bohrungen 13, welche sowohl in Längsrichtung 6 als auch in Querrichtung 11 verlaufen, werden die Kräfte von den Ankerplatten 9 und den Bodenflächen 3 der monolithischen Körper 1 und der Bodenplatte 7 gut und gleichmäßig abgetragen.

Im Montageendzustand ruhen auf den Montagerändern 8 der Bodenplatte 7 zur Vollendung des tunnelförmigen Suszeptors im Ausführungsbeispiel vier weitere Kreissegmente 2 mit unterschiedlicher Breite in Längsrichtung 6. Die Kreissegmente 2 sind mit Hilfe von im Montagerand 8 angebrachten Befestigungsschrauben 14 fixiert. Die Befestigungsschrauben 14 durchgreifen entsprechende Befestigungslöcher 15 in den Stirnenden der Kreissegmente 2.

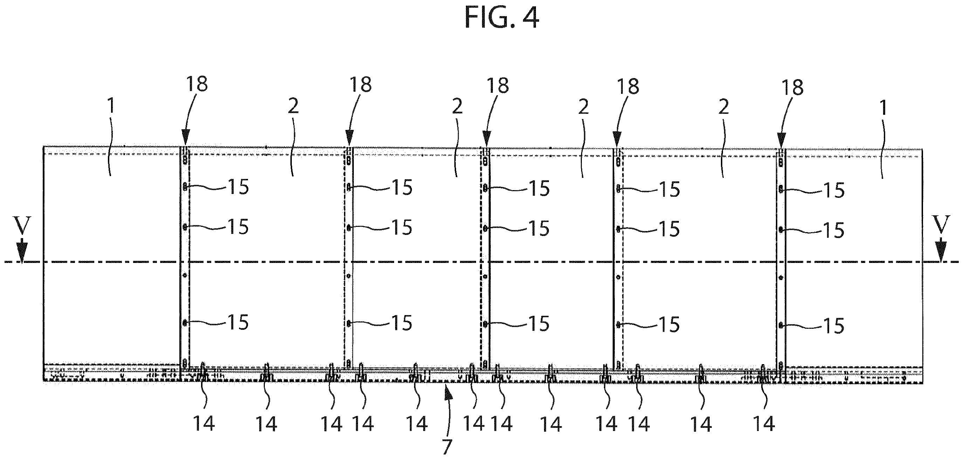

In Längsrichtung 6 stehen aus den Stirnseiten der Kreissegmente 2 Kragen 16 ab, welche in komplementäre Einformungen 17 am jeweiligen Nachbarmodul eingreifen. Die Kragen 16 und die Einformungen 17 schaffen die in Fig. 4 dargestellte Überlappungsbereiche 18 zwischen den Kreissegmenten 2 sowohl des monolithischen Körpers 1 als auch der auf der Bodenplatte 7 montierten Kreissegmente 2. Im Bereich der Einformungen 17 und der Kragen 16 sind wiederum stirnseitige Befestigungslöcher 15 angebracht, welche im Montageendzustand von Stiften durchsetzt sind. Mit Hilfe dieser Stifte entsteht eine nur formschlüssige Verbindung, so dass sich die Kreissegmente 2 in Längsrichtung 6 unter Wärmeeinfluss gegeneinander ausdehnen können.

### Bezugszeichenliste

- 1: monolithischer Körper
- 2: Kreissegment
- 3: Bodenfläche
- 4: Entwachsungsöffnung
- 5, 5': Ausnehmung
- 6: Längsrichtung
- 7: Bodenplatte
- 8: Montagerand
- 9: Ankerplatte
- 10, 10': Montagezunge
- 11: Querrichtung
- 12, 12': Montagefläche
- 13: Bohrung
- 14: Befestigungsschraube
- 15: Befestigungsloch
- 16: Kragen
- 17: Einformung
- 18: Überlappungsbereich

## Patentansprüche

1. Suszeptor für den Prozessraum einer Schutzgas- und Vakuum-Hochtemperatur Prozessanlage mit einem Kreissegment (2) größer als 180° als Körper eines Tunnels und mit einem das Kreissegment (2) zu einem geschlossenen Querschnitt ergänzenden Bodenelement (3, 7), wobei der Tunnel aus mindestens zwei an ihren Stirnflächen aneinander gelagerten, jeweils aus einem Kreissegment (2) und einem Bodenelement (3, 7) bestehenden Modulen zusammengesetzt ist,
**dadurch gekennzeichnet,**
**dass** mindestens ein endseitiges Modul als monolithischer Körper (1) mit einem in sich geschlossenen, aus einem Kreissegment (2) und einer Bodenfläche (3) bestehenden Querschnitt ausgebildet ist.

2. Suszeptor nach Anspruch 1, wobei an einer Beschickungsöffnung ein verschließbarer Deckel angeordnet ist und wobei das endseitige, als monolithischer Körper (1) ausgebildetes Modul in Längsrichtung (6) sich an diese Beschickungsöffnung anschließt.

3. Suszeptor nach Anspruch 1 oder 2 mit einer Beschickungsöffnung an einem Ende und einer Revisionsöffnung am anderen Ende mit jeweils einem verschließbaren Deckel und mit jeweils einem sich an jede dieser Öffnungen anschließenden, als monolithischer Körper (1) ausgebildeten Modul.

4. Suszeptor nach einem der Ansprüche 1 bis 3 mit einer im Anschluss an das eine beziehungsweise zwischen den beiden als monolithischer Körper (1) ausgebildeten Modulen angeordneten Bodenplatte (7) mit mehreren mit ihren Stirnflächen aneinander gereihten und mit der Bodenplatte (7) verbundenen Kreissegmenten (2).

5. Suszeptor nach Anspruch 4 mit jeweils einer Aussparung in der Bodenfläche (3) des monolithischen Körpers (1) und im angrenzenden Bereich der sich an den monolithischen Körper (1) anschließenden Bodenplatte (7) und mit einer den monolithischen Körper (1) und die Bodenplatte (7) verbindenden Ankerplatte (9).

6. Suszeptor nach Anspruch 5 mit jeweils zwei einander gegenüberliegenden und in Längsrichtung (6) aus der Ankerplatte (9) vorspringenden Montagezungen (10), mit zwei entsprechenden an den angrenzenden Rändern der Bodenplatte (7) und der Bodenfläche (3) des monolithischen Körpers (1) zurückspringenden Montageflächen (12) sowie mit zwei einander gegenüberliegenden, in Querrichtung (11) in die Aussparung (5) hineinragenden Montagezungen (10') an den Rändern der Bodenplatte (7) und der Bodenfläche (3) des monolithischen Körpers (1) und zwei entsprechenden, zurückspringenden Montageflächen (12, 12') an den Rändern der Ankerplatte (9).

7. Suszeptor nach Anspruch 6 mit mehreren nebeneinander angeordneten, die Montagezungen (10, 10') und die zugeordneten Montageflächen (12, 12') durchsetzenden Verschraubungen.

8. Suszeptor nach einem der Ansprüche 5 bis 7 mit einer aus mehreren Teilplatten zusammengesetzten und mit Ankerplatten (9) verbundenen Bodenplatte (7).

9. Suszeptor nach einem der Ansprüche 1 bis 8 mit einer in die Bodenfläche (3) des monolithischen Körpers (1) eingeformten Entwachsungsöffnung (4).

## Claims

1. Susceptor for the processing chamber of a protective-gas and vacuum high-temperature processing unit, comprising a circular segment (2) greater than 180° as a body of a tunnel and comprising a base element (3, 7) which completes the circular segment (2) to form a closed cross section, the tunnel being composed of at least two modules which are mounted on one another by their end faces and each consist of a circular segment (2) and a base element (3, 7), **characterised in that** at least one end module is in the form of a monolithic body (1) having a self-contained cross section consisting of a circular segment (2) and a base surface (3).

2. Susceptor according to claim 1, wherein a closable lid is arranged at a feed opening and wherein the end module, in the form of the monolithic body (1), adjoins said feed opening in the longitudinal direction (6).

3. Susceptor according to either claim 1 or 2 comprising a feed opening at one end and an inspection opening at the other end, each comprising a closable lid and each comprising a module, in the form of the monolithic body (1), adjoining each of said openings.

4. Susceptor according to any of claims 1 to 3 comprising a base plate (7) which is arranged so as to be adjoined to one or between the two modules in the form of the monolithic body (1), and comprising a plurality of circular segments (2) which are strung together by means of their end faces and are connected to the base plate (7).

5. Susceptor according to claim 4, comprising one recess in the base surface (3) of the monolithic body (1) and in the adjacent region of the base plate (7) adjoining the monolithic body (1) in each case, and comprising an anchor plate (9) connecting the monolithic body (1) and the base plate (7).

6. Susceptor according to claim 5, comprising two opposing mounting tabs (10) which project from the anchor plate (9) in the longitudinal direction (6) in each case, comprising two corresponding mounting surfaces (12) which are recessed at the adjacent edges of the base plate (7) and the base surface (3) of the monolithic body (1), and comprising two opposing mounting tabs (10') which project into the recess (5) in the transverse direction (11) at the edges of the base plate (7) and the base surface (3) of the monolithic body (1), and two corresponding recessed mounting surfaces (12, 12') at the edges of the anchor plate (9).

7. Susceptor according to claim 6, comprising a plurality of screw connections which are arranged side by side and pass through the mounting tabs (10, 10') and the associated mounting surfaces (12, 12').

8. Susceptor according to any of claims 5 to 7, comprising a base plate (7) which is composed of a plurality of sub-plates and connected to anchor plates (9).

9. Susceptor according to any of claims 1 to 8 comprising a dewaxing opening (4) formed in the base surface (3) of the monolithic body (1).

## Revendications

1. Suscepteur pour la chambre de traitement d'une installation de traitement à haute température sous gaz protecteur et sous vide, comportant un segment circulaire (2) supérieur à 180° comme corps d'un tunnel et un élément de base (3, 7) qui complète le segment circulaire (2) pour former une section transversale fermée, le tunnel étant composé d'au moins deux modules qui sont montés l'un sur l'autre sur leur face frontale et constitués chacun par un segment circulaire (2) et un élément de base (3, 7), **caractérisé en ce qu'**au moins un module d'extrémité est réalisé sous forme de corps monolithique (1) ayant une section transversale fermée en soi, constituée d'un segment circulaire (2) et d'une surface de base (3).

2. Suscepteur selon la revendication 1, dans lequel un couvercle refermable est disposé au niveau d'une ouverture de chargement et dans lequel le module d'extrémité, qui est réalisé sous forme de corps monolithique (1), est adjacent à cette ouverture de chargement dans la direction longitudinale (6).

3. Suscepteur selon la revendication 1 ou 2, comportant une ouverture de chargement au niveau d'une extrémité et une ouverture de maintenance au niveau de l'autre extrémité munies respectivement d'un couvercle refermable et munies respectivement d'un module réalisé sous la forme de corps monolithique (1) adjacent à chacune de ces ouvertures.

4. Suscepteur selon l'une des revendications 1 à 3, comportant une plaque de base (7) disposée à côté du module ou entre les deux modules réalisé(s) sous forme de corps monolithique (1), et qui présente plusieurs segments circulaires (2) qui sont alignés avec leurs faces frontales et sont reliés à la plaque de base (7).

5. Suscepteur selon la revendication 4, comportant respectivement un évidement dans la surface de base (3) du corps monolithique (1) et dans la zone adjacente de la plaque de base (7) adjacente au corps monolithique (1), et comportant une plaque d'ancrage (9) reliant le corps monolithique (1) et la plaque de base (7).

6. Suscepteur selon la revendication 5, comportant respectivement deux languettes de montage (10) opposées l'une à l'autre et faisant saillie de la plaque d'ancrage (9) dans la direction longitudinale (6), comportant deux surfaces de montage (12) correspondantes qui font saillie sur les bords adjacents de la plaque de base (7) et la surface de base (3) du corps monolithique (1), et comportant également deux languettes de montage (10') qui sont opposées l'une à l'autre et pénètrent dans l'évidement (5) en direction transversale (11) sur les bords de la plaque de base (7) et de la surface de base (3) du corps monolithique (1) et deux surfaces de montage (12, 12') correspondantes en évidement sur les bords de la plaque d'ancrage (9).

7. Suscepteur selon la revendication 6, comportant plusieurs raccords vissés disposés côte à côte et traversant les languettes de montage (10, 10') et les surfaces de montage associées (12, 12').

8. Suscepteur selon l'une des revendications 5 à 7 comportant une plaque de base (7) composée d'une pluralité de plaques partielles et reliée à des plaques d'ancrage (9).

9. Suscepteur selon l'une des revendications 1 à 8 comportant une ouverture de déparaffinage (4) formée dans la surface de base (3) du corps monolithique (1).
